# FASCICULE DE BREVET EUROPEEN

(11) **EP 3 811 411 B1**
(45) Date de publication et mention de la délivrance du brevet: **18.11.2026**
(21) Numéro de dépôt: 19745699.9
(22) Date de dépôt: 21.06.2019
(51) Int. Cl.: H10F 39/18, H10F 39/00, H10D 86/00

(54) **CAPTEUR D'IMAGE DE TYPE FACE AVANT ET PROCEDE DE FABRICATION D'UN TEL CAPTEUR**
FRONTSEITIGER BILDSENSOR UND VERFAHREN ZUR HERSTELLUNG SOLCH EINES SENSORS
FRONT-SIDE-TYPE IMAGE SENSOR AND METHOD FOR PRODUCING SUCH A SENSOR

(30) Priorité: 21.06.2018 FR 1855540
(43) Date de publication de la demande: 28.04.2021
(73) Titulaire: SOITEC, 38190 Bernin (FR)
(72) Inventeur: SCHWARZENBACH, Walter, 38330 Saint Nazaire Les Eymes (FR); SELLIER, Manuel, 38000 Grenoble (FR); ECARNOT, Ludovic, 38000 Grenoble (FR)
(74) Mandataire: Regimbeau
(86) Numéro de dépôt international: PCT/FR2019/051515
(87) Numéro de publication internationale: WO 2019/243751

(56) Documents cités:
- WO-A1-2011/054852
- US-A1- 2005 205 930
- US-A1- 2013 214 356
- US-A1- 2016 020 138

## Description

### DOMAINE DE L'INVENTION

La présente invention concerne un capteur d'image de type face avant, ainsi qu'un procédé de fabrication d'un tel capteur d'image.

### ETAT DE LA TECHNIQUE

Le document US 2016/0118431 décrit un capteur d'image de type « face avant » (« front-side imager », selon la terminologie anglo-saxonne).

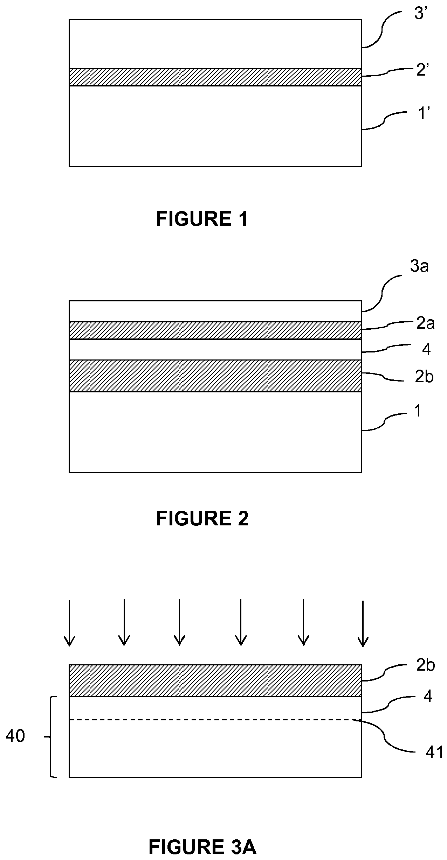

Comme illustré sur la figure 1, ledit capteur comprend un substrat de type semi-conducteur sur isolant (SOI, acronyme du terme anglo-saxon « Semiconductor-On-Insulator ») comprenant, de sa face arrière vers sa face avant, un substrat support 1' de silicium présentant un certain dopage, une couche 2' d'oxyde de silicium dite « couche d'oxyde enterrée » (BOX, acronyme du terme anglo-saxon « Buried OXide »), et une couche 3' dite couche active de silicium présentant un dopage pouvant être différent de celui de la couche support 1', dans laquelle est défini un réseau matriciel de photodiodes définissant chacune un pixel.

Selon un mode de réalisation, la couche d'oxyde enterrée est choisie relativement mince (c'est-à-dire présentant une épaisseur inférieure à 100 nm, notamment de l'ordre de 20 nm) pour remplir la fonction du diélectrique d'un condensateur. La partie du substrat située en dessous de la couche d'oxyde enterrée est polarisée à une tension électrique différente de celle de la couche active, ce qui permet de passiver l'interface entre la couche diélectrique et cette couche active.

La tension électrique à appliquer à la partie du substrat située sous le BOX dépend de l'épaisseur de ce dernier. La différence de potentiel à appliquer est d'autant plus faible que la couche d'oxyde enterrée est mince.

Inversement, si la couche d'oxyde enterrée est choisie relativement épaisse (c'est-à-dire présentant une épaisseur de l'ordre de 100 à 200 nm ou plus), elle présente des propriétés optiquement réfléchissantes et permet de provoquer une réflexion des photons incidents de sorte à les confiner dans la couche active, en particulier dans le cas de photons dont la longueur d'onde est dans la gamme du proche infrarouge.

Les gammes d'épaisseur optimales pour chacune de ces deux fonctions ne coïncidant pas, l'homme du métier est amené à effectuer un compromis entre la réflectivité de la couche d'oxyde enterrée et son aptitude à polariser chaque pixel sous l'application d'une faible différence de potentiel entre la couche active et le substrat.

Le document US 2005/205930 décrit, en référence à la figure 2A, un capteur d'image de type face avant comprenant deux couches électriquement isolantes.

### EXPOSE DE L'INVENTION

Un but de l'invention est de concevoir un capteur d'image de type face avant qui soit plus performant que les capteurs existants, et notamment un substrat à partir duquel ledit capteur puisse être obtenu.

De préférence, ce substrat doit pouvoir être fabriqué à bas coût.

A cet effet, un premier objet de l'invention concerne un capteur d'image de type face avant selon la revendication 1. Le capteur d'image comprend successivement :
- un substrat support semi-conducteur,
- une première couche de séparation électriquement isolante, et
- une couche semi-conductrice, monocristalline, dite couche active, comprenant un réseau matriciel de photodiodes, agencée du côté de la face avant du capteur,
ledit capteur d'image étant caractérisé en ce qu'il comprend en outre, entre le substrat support et la première couche électriquement isolante :
- une seconde couche de séparation électriquement isolante et
- une seconde couche électriquement conductrice ou semi-conductrice, dite couche intermédiaire, agencée entre la seconde couche de séparation et la première couche de séparation, la seconde couche de séparation étant plus épaisse que la première couche de séparation.

Par « face avant » on entend dans le présent texte la face du capteur d'image destinée à être exposée à un rayonnement lumineux, qui se trouve du même côté de la structure que les composants électroniques associés.

La première couche de séparation présente avantageusement une épaisseur comprise entre 10 et 100 nm.

La seconde couche de séparation présente avantageusement une épaisseur comprise entre 100 et 300 nm.

Selon un mode de réalisation, la couche intermédiaire est en un matériau amorphe ou polycristallin dopé.

Selon un mode de réalisation, la couche intermédiaire est en silicium dopé.

De manière alternative, la couche intermédiaire est en un matériau métallique.

La couche intermédiaire présente avantageusement une épaisseur comprise entre 20 et 150 nm.

Selon un mode de réalisation, la couche active comprend une couche germe de silicium.

Selon un autre mode de réalisation, la couche germe est une couche de silicium-germanium.

Selon une forme d'exécution, la couche active comprend en outre une couche monocristalline de silicium-germanium sur la couche germe.

De manière particulièrement avantageuse, la teneur en germanium de la couche de silicium-germanium est inférieure ou égale à 10%.

De préférence, l'épaisseur de la couche de silicium-germanium est inférieure à une épaisseur critique définie comme étant une épaisseur au-delà de laquelle une relaxation du silicium-germanium se produit.

Selon une autre forme de réalisation, la couche active comprend en outre une couche monocristalline de silicium sur la couche germe.

Selon un mode de réalisation, le capteur d'image comprend en outre, sur la couche active, une couche dite couche de confinement optique présentant un coefficient de réflexion optique de la face avant vers la couche active supérieur au coefficient de réflexion de la couche active vers la face avant, ladite couche de confinement optique comprend une couche de nitrure de titane entre deux couches d'oxyde de silicium.

Selon un mode de réalisation, chaque photodiode est séparée d'une photodiode adjacente par au moins une tranchée électriquement isolante s'étendant jusqu'à la première couche électriquement isolante.

De manière avantageuse, ladite tranchée comprend un via semi-conducteur ou électriquement conducteur s'étendant jusqu'à la couche intermédiaire entre des parois en un matériau électriquement isolant.

Selon un mode de réalisation, ladite au moins une tranchée s'étend au travers de la couche de confinement optique.

Selon un mode de réalisation, chaque tranchée comprend une première paroi s'étendant jusqu'à la couche intermédiaire et une seconde paroi s'étendant au moins en partie dans la seconde couche de séparation de sorte à isoler électriquement une portion de la couche intermédiaire, le via semi-conducteur ou électriquement conducteur étant connecté électriquement à ladite portion de la couche intermédiaire.

Le capteur tel que décrit ci-dessus est formé à partir d'un substrat pour un capteur d'image de type face avant, comprenant successivement :
- le substrat support semi-conducteur,
- la première couche de séparation électriquement isolante, et
- une couche semi-conductrice, monocristalline, dite couche germe, adaptée pour la croissance épitaxiale d'une couche semi-conductrice monocristalline,
ledit substrat comprenant en outre, entre le substrat support et la première couche électriquement isolante :
- la seconde couche de séparation électriquement isolante et
- la seconde couche électriquement conductrice ou semi-conductrice, dite couche intermédiaire, agencée entre la seconde couche de séparation et la première couche de séparation, la seconde couche de séparation étant plus épaisse que la première couche de séparation.

La couche germe peut être une couche de silicium ou une couche de silicium-germanium.

Le substrat peut comprendre en outre une couche monocristalline de silicium-germanium sur la couche germe, ladite couche de silicium-germanium formant, avec la couche germe, la couche active du capteur d'image.

Le substrat peut comprendre en outre une couche monocristalline de silicium sur la couche germe, ladite couche de silicium formant, avec la couche germe, la couche active du capteur d'image.

Ledit substrat peut être fabriqué par un procédé comprenant les étapes suivantes :
- fourniture d'un premier substrat donneur,
- formation d'une zone de fragilisation dans ledit premier substrat donneur, de sorte à délimiter une première couche semi-conductrice,
- transfert de ladite première couche sur un substrat support semi-conducteur, une couche électriquement isolante étant à l'interface entre le substrat donneur et le substrat support de sorte à former une structure comprenant le substrat support, la couche électriquement isolante, et la couche transférée,
- fourniture d'un second substrat donneur,
- formation d'une zone de fragilisation dans ledit second substrat donneur, de sorte à délimiter une couche semi-conductrice monocristalline,
- transfert de ladite couche semi-conductrice monocristalline sur la structure, une couche électriquement isolante étant à l'interface entre le second substrat donneur et la structure.

De manière alternative, le substrat peut être fabriqué par un procédé comprenant les étapes suivantes :
- formation d'une structure par dépôt d'une couche semi-conductrice ou électriquement conductrice sur un substrat support recouvert d'une couche électriquement isolante,
- fourniture d'un substrat donneur,
- formation d'une zone de fragilisation dans ledit substrat donneur, de sorte à délimiter une couche semi-conductrice monocristalline,
- transfert de ladite couche semi-conductrice monocristalline sur la structure, une couche électriquement isolante étant à l'interface entre le second substrat donneur et la structure.

Un autre objet de l'invention concerne un procédé de fabrication d'un capteur d'image de type face avant tel que décrit précédemment, selon la revendication 17 ou la revendication 18.

Selon une forme d'exécution, ledit procédé de fabrication comprend les étapes suivantes :
- fourniture d'un premier substrat donneur,
- formation d'une zone de fragilisation dans ledit premier substrat donneur, de sorte à délimiter une première couche semi-conductrice,
- transfert de ladite première couche sur un substrat support semi-conducteur, une couche électriquement isolante (seconde couche de séparation) étant à l'interface entre le substrat donneur et le substrat support de sorte à former une structure comprenant le substrat support, la couche électriquement isolante, et la couche transférée,
- fourniture d'un second substrat donneur,
- formation d'une zone de fragilisation dans ledit second substrat donneur, de sorte à délimiter une couche semi-conductrice monocristalline,
- transfert de ladite couche semi-conductrice monocristalline sur la structure, une couche électriquement isolante (première couche de séparation) étant à l'interface entre le second substrat donneur et la structure, de sorte à former un ensemble comprenant successivement le substrat support, la seconde couche de séparation, la première couche semi-conductrice, la première couche de séparation et la couche semi-conductrice monocristalline transférée, la seconde couche de séparation étant plus épaisse que la première couche de séparation,
- croissance épitaxiale d'une couche semi-conductrice monocristalline (3b) sur la couche semi-conductrice monocristalline (3a) transférée, ladite couche épitaxiale semi-conductrice monocristalline (3b) formant, avec la couche semi-conductrice monocristalline (3a) transférée, une couche active (3) du capteur d'image agencée du côté de la face avant du capteur, adaptée pour former un réseau matriciel de photodiodes.

Selon une forme d'exécution alternative, ledit procédé de fabrication comprend les étapes suivantes :
- formation d'une structure par dépôt d'une couche semi-conductrice ou électriquement conductrice sur un substrat support recouvert d'une couche électriquement isolante (seconde couche de séparation),
- fourniture d'un substrat donneur,
- formation d'une zone de fragilisation dans ledit substrat donneur, de sorte à délimiter une couche semi-conductrice monocristalline,
- transfert de ladite couche semi-conductrice monocristalline sur la structure, une couche électriquement isolante (première couche de séparation) étant à l'interface entre le substrat donneur et la structure, de sorte à former un ensemble comprenant successivement le substrat support, la seconde couche de séparation, la couche semi-conductrice ou électriquement conductrice, la première couche de séparation et la couche semi-conductrice monocristalline transférée, la seconde couche de séparation étant plus épaisse que la première couche de séparation,
- croissance épitaxiale d'une couche semi-conductrice monocristalline (3b) sur la couche semi-conductrice monocristalline (3a) transférée, ladite couche épitaxiale semi-conductrice monocristalline (3b) formant, avec la couche semi-conductrice monocristalline (3a) transférée, une couche active (3) du capteur d'image agencée du côté de la face avant du capteur, adaptée pour former un réseau matriciel de photodiodes.

Lesdits procédés comprennent en outre une étape de formation d'un réseau matriciel de photodiodes dans la couche active.

Par ailleurs, une couche dite de confinement optique peut être formée sur la couche active, ladite couche de confinement optique présentant un coefficient de réflexion optique de la face avant vers la couche active supérieur au coefficient de réflexion de la couche active vers la face avant.

### DESCRIPTION DES FIGURES

D'autres caractéristiques et avantages de l'invention ressortiront de la description détaillée qui va suivre, en référence aux dessins annexés sur lesquels :
- la figure 1 est une vue en coupe d'un substrat SOI pour capteur d'image face avant tel que décrit dans le document US 2016/0118431 ;
- la figure 2 est une vue en coupe d'un substrat SOI, prêt pour une épitaxie pour former la couche active d'un capteur d'image face avant selon l'invention ;
- les figures 3A à 3E illustrent de manière schématique les principales étapes d'un procédé de fabrication du substrat de la figure 2,
- les figures 4A à 4D illustrent de manière schématique les principales étapes d'un autre procédé de fabrication du substrat de la figure 2,
- la figure 5 illustre le substrat obtenu après croissance épitaxiale de la couche active sur le substrat de la figure 2,
- la figure 6 illustre le substrat obtenu après formation de tranchées électriquement isolantes dans le substrat de la figure 5 pour individualiser chaque pixel du capteur d'image,
- la figure 7A illustre le substrat obtenu après formation d'une couche de confinement optique sur le substrat de la figure 6,
- la figure 7B illustre le substrat obtenu après formation d'une couche de confinement optique sur le substrat de la figure 5 et la formation de tranchées électriquement isolantes dans ledit substrat,
- les figures 8 et 9 illustrent des variantes du substrat de la figure 6, dans lequel chaque tranchée comprend un via semi-conducteur en contact avec la couche intermédiaire.

Pour des raisons de lisibilité des dessins, les différentes couches ne sont pas nécessairement représentées à l'échelle.

### DESCRIPTION DETAILLEE DE MODES DE REALISATION DE L'INVENTION

Contrairement au substrat de la figure 1, un substrat pour capteur d'image selon l'invention comprend un empilement comportant deux couches de séparation électriquement isolantes séparées par une couche électriquement conductrice ou semi-**conductrice,** dite couche intermédiaire. L'empilement est interposé entre le substrat support et la couche active, et il est configuré pour réfléchir les photons traversant la couche active vers cette même couche active.

Le substrat support est généralement obtenu par découpe d'un lingot monocristallin. Ledit substrat remplit essentiellement une fonction de support mécanique du capteur d'image. Le substrat support peut comprendre un matériau choisi parmi le silicium, les matériaux semi-conducteurs III-V, le verre, la silice, le saphir, l'alumine, le nitrure d'aluminium, le carbure de silicium ou encore une céramique ou un alliage métallique. De manière avantageuse, le substrat support est en silicium. Son dopage (s'il s'agit de silicium), sa nature et ses caractéristiques peuvent être optimisées afin d'intégrer, de façon hybride, sous la forme d'un « Système on Chip », des dispositifs électroniques autres que le capteur d'image. Ledit dopage du substrat peut être homogène sur toute l'épaisseur du matériau ou limitée à une portion de celui-ci. Préférentiellement, la zone dopée est adjacente à une des deux couches de séparation.

La couche active comprend un matériau semi-conducteur monocristallin et est destinée à recevoir un réseau matriciel de photodiodes permettant la capture d'images.

Les deux couches de séparation de part et d'autre de la couche intermédiaire présentent des épaisseurs différentes et présentent des fonctions différentes dans le fonctionnement du capteur d'image.

La première couche de séparation est située du côté de la face avant, et elle est plus fine que la seconde couche de séparation, qui est disposée du côté de la face arrière.

La première couche de séparation a pour fonction de permettre le transfert d'une polarisation de la couche intermédiaire vers la couche active. La seconde couche de séparation a pour fonction d'isoler électriquement la couche intermédiaire du substrat, et de permettre que l'empilement des couches séparant la couche active du substrat support présente une réflectivité adaptée vis-à-vis des photons provenant de la couche active.

Chacune des deux couches de séparation est réalisée en un matériau électriquement isolant, tel qu'un matériau diélectrique, par exemple un oxyde, tel qu'un oxyde de silicium thermique ou déposé, ou encore un oxyde de nitrure. La structure comprenant ces deux couches de séparation électriquement isolantes peut alors être qualifiée de « double BOX », c'est-à-dire « double couche d'oxyde enterrée ».

Du côté de sa face avant, le substrat comprend une couche germe sur la première couche de séparation, ladite couche germe étant une couche semi-conductrice monocristalline adaptée pour la croissance épitaxiale d'une couche semi-conductrice monocristalline destinée à former, avec la couche germe, la couche active du capteur d'image.

Le matériau de la couche germe est choisi en fonction du matériau de la couche épitaxiale, et présente notamment un paramètre de maille adapté pour permettre la croissance de la couche épitaxiale en évitant ou tout au moins en minimisant la génération de défauts cristallins tels que des dislocations.

La couche germe et la couche épitaxiale peuvent être constituées du même matériau (homoépitaxie) ou de deux matériaux différents (hétéroépitaxie).

La couche épitaxiale peut être en silicium. Dans ce cas, la couche germe est avantageusement en silicium.

De manière préférée, la couche épitaxiale est en silicium-germanium (SiGe) car le silicium-germanium présente un coefficient d'absorption optique supérieur à celui du silicium, notamment dans l'infrarouge, ce coefficient d'absorption étant d'autant plus grand que la concentration en germanium est grande. La couche germe peut alors être en silicium-germanium ou en silicium. Dans ce dernier cas, la conception de la couche épitaxiale ne doit pas prendre en compte que la concentration en germanium mais aussi l'épaisseur de ladite couche. En effet, si la couche de SiGe est formée par épitaxie sur une couche germe de silicium, dont le paramètre de maille est différent de celui du silicium-germanium, il se produit une relaxation de la couche de SiGe au-delà d'une certaine épaisseur, dite épaisseur critique. Cette relaxation se traduit par la formation de dislocations au sein de la couche de SiGe. De telles dislocations rendraient la couche de SiGe impropre à la fonction de la couche active en particulier pour un capteur d'image et doivent donc être évitées. Or, l'épaisseur critique est d'autant plus faible que la concentration en germanium est grande. L'épaisseur de la couche épitaxiale et la concentration en germanium de ladite couche résultent donc d'un compromis entre :
- d'une part, une épaisseur suffisamment grande pour capturer un maximum de photons dans les longueurs d'onde du proche infrarouge,
- d'autre part, une concentration suffisante en germanium pour accroître la capacité d'absorption des photons par la couche active en particulier dans le proche infrarouge, et
- enfin, une épaisseur limitée (dépendant de la concentration), inférieure à l'épaisseur critique, pour éviter la relaxation du silicium-germanium et la création de défauts cristallins (dislocations) qui en résulte.

Typiquement, on cherche à maximiser l'épaisseur et la concentration en germanium de la couche épitaxiale pour avoir la meilleure absorption possible dans l'infrarouge. De préférence, la teneur en germanium de la couche active est inférieure ou égale à 10%. **En** effet, l'épaisseur critique d'une couche de Si_{0,9}Ge_{0,1} est de l'ordre de quelques micromètres, ce qui convient à la couche active d'un capteur d'image de type « face avant ».

La couche intermédiaire peut être en un matériau semi-conducteur ou encore en un matériau électriquement conducteur. En effet, cette couche intermédiaire a pour fonction de permettre une polarisation de la couche active par l'arrière, autrement dit via une zone disposée entre le substrat support et la deuxième couche électriquement isolante. Une telle polarisation permet l'application d'une différence de potentiel entre la couche active et la couche intermédiaire enterrée.

La couche intermédiaire peut être monocristalline mais cela n'est pas indispensable car on ne recherche pas une capacité à assurer une conduction des électrons au travers de cette couche, ni une quelconque propriété électronique comme il est communément considéré pour des applications autres que celle des capteurs d'image, mais uniquement une capacité à modifier le potentiel électrique de la couche active à la périphérie de la première couche de séparation.

La couche intermédiaire peut ainsi être polycristalline et/ou amorphe, ce qui la rend moins onéreuse à fabriquer, et/ou métallique. Cette couche peut être plus ou moins dopée de manière à assurer une capacité à être polarisée. Une couche intermédiaire semi-conductrice est avantageusement en silicium. Ladite couche présente alors typiquement une épaisseur comprise entre 20 et 150 nm.

La première couche de séparation, électriquement isolante, qui est interposée entre la couche active et la couche intermédiaire, remplit la fonction du diélectrique d'un condensateur, et permet ainsi de polariser la couche active à la périphérie du matériau électriquement isolant. A cet effet, la première couche de séparation est choisie suffisamment mince pour minimiser la différence de potentiel à appliquer entre la couche intermédiaire et la couche active. Typiquement, l'épaisseur de la première couche de séparation est comprise entre 10 et 100 nm.

L'épaisseur de la première couche de séparation est en revanche trop faible pour permettre de réfléchir tous les photons traversant la couche active, notamment les photons dont la longueur d'onde est dans la gamme du proche infrarouge. Par conséquent, des photons traversant la couche active sont susceptibles de passer au travers de la première couche de séparation et de la couche intermédiaire.

La seconde couche de séparation a pour fonction d'induire une réflexion des photons, notamment des photons dont la longueur d'onde est dans la gamme du proche infrarouge, vers le pixel formé dans la couche active au travers de l'empilement comportant : la seconde couche de séparation, la couche intermédiaire et la première couche de séparation. A cet effet, cette seconde couche de séparation présente une épaisseur suffisamment grande pour présenter une réflectivité (ou coefficient de réflexion optique) élevée notamment dans le domaine du proche infrarouge. Typiquement, l'épaisseur de la seconde couche de séparation, réalisée par exemple en oxyde de silicium est comprise entre 100 et 300 nm.

La figure 2 est une vue en coupe d'un substrat pour un capteur d'image face avant selon un mode de réalisation de l'invention.

Ledit substrat comprend successivement, de sa face arrière vers sa face avant :
- un substrat support 1, préférentiellement semi-conducteur,
- la seconde couche de séparation électriquement isolante, 2b,
- la couche semi-conductrice intermédiaire 4,
- la première couche de séparation électriquement isolante 2a, et
- la couche germe 3a semi-conductrice, monocristalline.

On va maintenant décrire des exemples de procédés de fabrication du substrat illustré sur la figure 2.

Selon une première forme d'exécution, illustrée sur les figures 3A-3E, le procédé de fabrication du substrat comprend deux étapes successives de transfert de couche, par exemple en mettant en œuvre le procédé Smart Cut^{™} à deux reprises.

D'une part, en référence à la figure 3A, on fournit un premier substrat donneur 40 comprenant un matériau semi-conducteur destiné à constituer la couche intermédiaire 4.

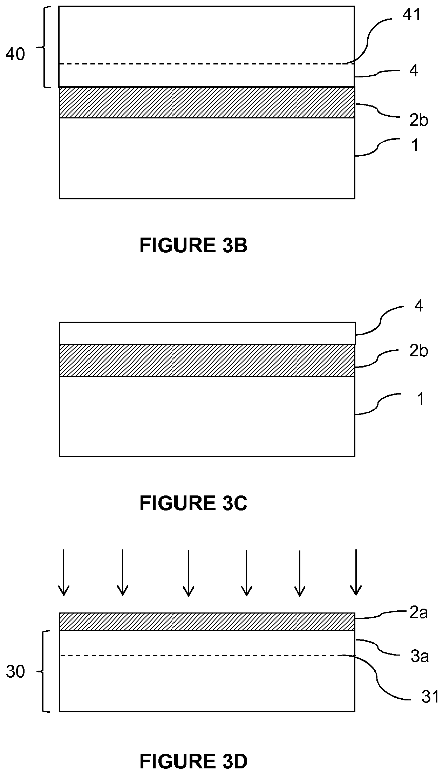

D'autre part, en référence à la figure 3B, on fournit le substrat support 1, et l'on colle le substrat donneur sur le substrat support, la seconde couche de séparation 2b étant à l'interface de collage. Comme représenté sur la figure 3A, ladite couche 2b est par exemple préalablement formée à la surface du premier substrat donneur 40 avant le collage. De manière alternative, la couche 2b pourrait être formée sur le substrat support 1, voire constituée de l'assemblage d'une couche formée sur le premier substrat donneur et d'une couche formée sur le substrat support.

On amincit ensuite le premier substrat donneur de sorte à transférer une couche 4 du matériau semi-conducteur sur le substrat receveur. Cet amincissement peut être effectué par polissage ou gravure du matériau semi-conducteur par la face opposée à l'interface de collage. Toutefois, de manière avantageuse, on procède, avant l'étape de collage, à la formation d'une zone de fragilisation 41 dans le matériau semi-conducteur de sorte à délimiter une couche superficielle 4 à transférer ; ladite zone de fragilisation peut être formée par implantation d'espèces atomiques telles que de l'hydrogène et/ou de l'hélium (ladite implantation étant schématisée par les flèches sur la figure 3A). Après l'étape de collage, l'amincissement consiste à détacher le premier substrat donneur 40 le long de la zone de fragilisation 41, ce qui conduit au transfert de la couche intermédiaire 4 sur le substrat support 1 (cf. figure 3C). Typiquement, l'épaisseur de la couche 4 transférée est inférieure ou égale à 300 nm. Eventuellement, on effectue un traitement de finition de la surface libre de la couche transférée afin de favoriser la mise en œuvre d'une nouvelle étape de transfert de couche, ce traitement pouvant conduire à amincir et réduire la rugosité de la couche transférée.

En référence à la figure 3D, on fournit par ailleurs un second substrat donneur 30 comprenant un matériau monocristallin adapté pour la croissance épitaxiale de la couche active et destiné à constituer la couche germe 3a.

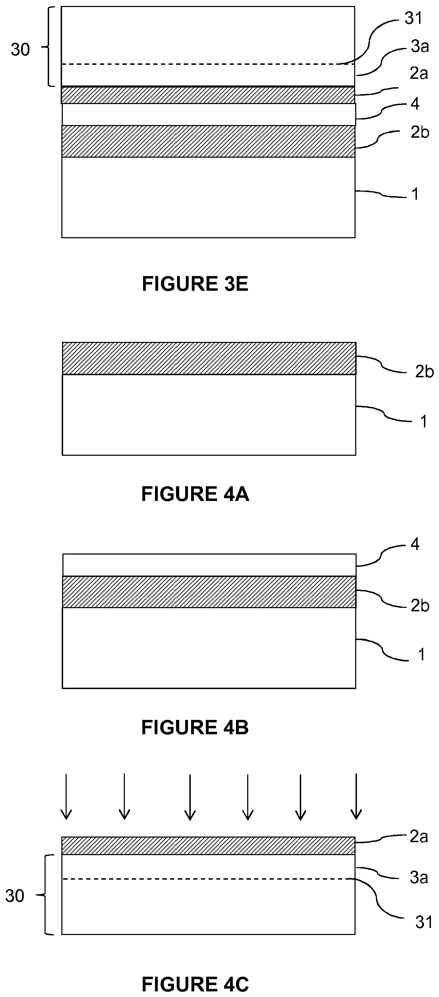

En référence à la figure 3E, on colle ce second substrat donneur sur la couche intermédiaire 4 précédemment transférée sur le substrat support 1, la première couche de séparation 2a étant à l'interface de collage. Comme représenté sur la figure 3D, ladite couche 2a est par exemple préalablement formée à la surface du second substrat donneur 30 avant le collage. De manière alternative, la couche 2a pourrait être formée sur la couche intermédiaire 4 après son transfert sur le substrat support 1, voire constituée de l'assemblage d'une couche formée sur le second substrat donneur et d'une couche formée sur la couche intermédiaire transférée.

On amincit ensuite le second substrat donneur de sorte à transférer une couche 3a du matériau semi-conducteur sur le substrat receveur, ce qui permet d'obtenir le substrat représenté sur la figure 2. Cet amincissement peut être effectué par polissage ou gravure du matériau semi-conducteur de sorte à obtenir l'épaisseur et l'état de surface souhaité pour l'épitaxie de la couche active. Toutefois, de manière avantageuse, on procède, avant l'étape de collage, à la formation d'une zone de fragilisation 31 dans le matériau semi-conducteur monocristallin de sorte à délimiter la couche germe 3a à transférer. Après l'étape de collage, l'amincissement consiste à détacher le second substrat donneur 30 le long de la zone de fragilisation 31, ce qui conduit au transfert de la couche germe 3a sur la structure constituée du substrat support 1, de la seconde couche de séparation 2b et de la couche intermédiaire 4. Typiquement, l'épaisseur de la couche germe transférée est inférieure ou égale à 300 nm. Eventuellement, on effectue un traitement de finition de la surface libre de la couche germe transférée afin de favoriser la mise en œuvre de l'épitaxie, ce traitement pouvant conduire à amincir la couche transférée et/ou à réduire sa rugosité.

Selon une seconde forme d'exécution, illustrée sur les figures 4A-4D, le procédé de fabrication du substrat comprend une étape de dépôt de la couche intermédiaire (au lieu d'un transfert de ladite couche à partir d'un substrat donneur) et une seule étape de transfert de couche, pour la formation de la couche germe.

Cette seconde forme d'exécution du procédé tire avantage du fait que la couche semi-conductrice intermédiaire ne présente pas de fonction optique ni électronique et peut donc être réalisée en un matériau qui n'est pas monocristallin mais polycristallin et/ou amorphe. Ainsi, la couche intermédiaire peut être formée par dépôt sur la seconde couche électriquement isolante 2b sous-jacente.

En référence à la figure 4A, on fournit le substrat support 1 recouvert de la seconde couche de séparation 2b. Ladite couche 2b est typiquement formée par oxydation thermique du substrat support 1 si celui-ci est en silicium. Celle-ci peut également être formée par un dépôt chimique en phase vapeur (technique CVD, acronyme du terme anglo-saxon « Chemical Vapor Deposition ») qui peut ensuite nécessiter ou non un traitement visant à réduire sa rugosité.

En référence à la figure 4B, on dépose la couche intermédiaire 4, par exemple en silicium polycristallin et/ou amorphe. Ce dépôt peut être mis en œuvre par CVD ou par épitaxie à différentes températures (allant de 300°C à plus de 800°C selon les techniques utilisées). Ce dépôt peut être suivi d'un polissage ou d'un traitement de lissage par exemple de type plasma de la couche 4 afin d'obtenir un état de surface adapté pour le collage puis le transfert de la couche germe.

En référence à la figure 4C, on fournit un substrat donneur 30 comprenant un matériau monocristallin adapté pour la croissance épitaxiale de la couche active et destiné à constituer la couche germe 3a. Selon un mode de réalisation, la couche germe 3a est délimitée par une zone de fragilisation 31 formée par implantation d'espèces atomiques, telles que de l'hydrogène et/ou de l'hélium.

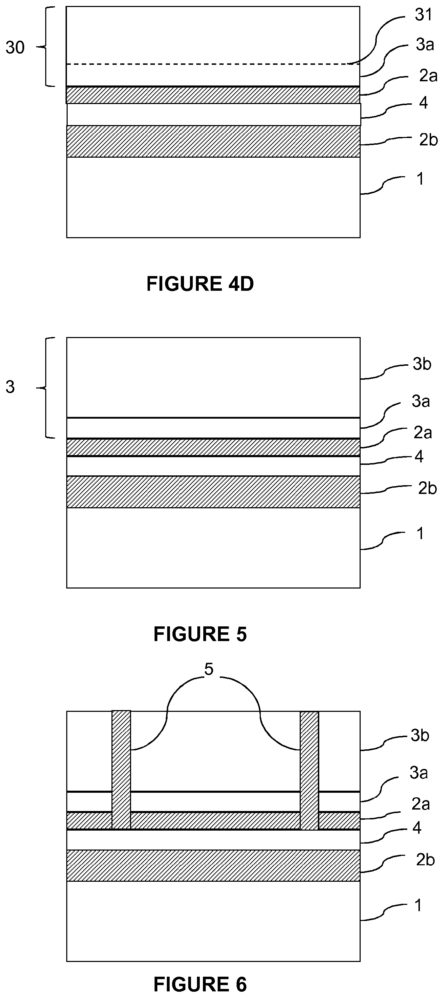

En référence à la figure 4D, on colle le substrat donneur 30 sur la couche intermédiaire 4 précédemment déposée sur le substrat support 1, la première couche de séparation 2a étant à l'interface de collage. Comme représenté sur la figure 4C, ladite couche 2a est par exemple préalablement formée à la surface du substrat donneur 30 avant le collage. De manière alternative, la couche 2a pourrait être formée sur la couche intermédiaire 4 après son dépôt sur le substrat support 1, voire constituée de l'assemblage d'une couche formée sur le substrat donneur et d'une couche formée sur la couche intermédiaire déposée.

On amincit ensuite le substrat donneur 30 de sorte à transférer la couche 3a sur la couche intermédiaire 4, ce qui permet d'obtenir le substrat représenté sur la figure 2. De manière avantageuse, l'amincissement consiste à détacher le substrat donneur 30 le long de la zone de fragilisation 31. De manière alternative, l'amincissement pourrait être effectué par polissage ou gravure du substrat donneur par la face opposée à l'interface de collage de sorte à obtenir l'épaisseur et l'état de surface souhaité pour l'épitaxie de la couche active. Typiquement, l'épaisseur de la couche germe transférée est inférieure ou égale à 300 nm. Eventuellement, on effectue un traitement de finition de la surface libre de la couche germe transférée afin de favoriser la mise en œuvre de l'épitaxie, ce traitement pouvant conduire à amincir de la couche transférée et/ou à réduire sa rugosité.

Cette seconde forme d'exécution du procédé est particulièrement avantageuse en ce qu'elle est moins onéreuse puisqu'elle implique une seule étape de transfert de couche au lieu de deux.

Quel que soit le procédé de fabrication de la structure illustrée sur la figure 2, on met ensuite en œuvre, sur la couche germe 3a transférée, la croissance épitaxiale d'une couche 3b de silicium-germanium ou de silicium jusqu'à l'obtention de l'épaisseur souhaitée pour la couche active (cf. figure 5), c'est-à-dire typiquement supérieure ou égale à 1 µm. La couche épitaxiale 3b peut être légèrement dopée.

La couche germe 3a et la couche épitaxiale 3b forment ensemble la couche active 3. L'épaisseur de la couche épitaxiale 3b étant nettement supérieure à celle de la couche germe 3a, on considère que les propriétés optiques de la couche active sont essentiellement imposées par la couche épitaxiale 3b, même si les couches 3a et 3b sont en des matériaux différents.

Ainsi, par exemple, si la couche épitaxiale est en SiGe mais que la couche germe n'est pas en SiGe, par exemple lorsqu'elle est en silicium, la couche de silicium est suffisamment mince (d'une épaisseur inférieure ou égale à 300 nm) par rapport à l'épaisseur de la couche de SiGe pour ne pas affecter notablement les propriétés de la couche active en termes d'absorption dans l'infrarouge.

Cependant, il est possible de modifier la nature de la couche germe, par exemple au moyen d'un procédé dit « thermal mixing » selon la terminologie anglo-saxonne. De manière connue en elle-même, ledit procédé comprend une oxydation de la couche de SiGe épitaxiée sur une couche de silicium, ladite oxydation ayant pour effet de consommer uniquement le silicium (pour former de l'oxyde de silicium) et de faire migrer le germanium vers la face opposée à la surface libre de la couche de SiGe. On obtient alors en surface une couche de SiO₂ que l'on peut éliminer par gravure.

En référence à la figure 6, on forme dans la couche active 3 une pluralité de tranchées 5 électriquement isolantes qui s'étendent jusqu'à la première couche électriquement isolante 2a. Ces tranchées sont connues dans le domaine des capteurs d'image sous le terme CDTI, acronyme du terme anglo-saxon « Capacitive Deep Trench Isolation », c'est-à-dire tranchée profonde d'isolation. Chaque région de la couche active délimitée par de telles tranchées est destinée à former un pixel du capteur d'image. A cet effet, une étape ultérieure du procédé de fabrication du capteur d'image est de former une photodiode (non représentée) dans ladite région. Les procédés de fabrication des tranchées et des photodiodes sont connus de l'homme du métier et ne seront donc pas décrits en détail dans le présent texte.

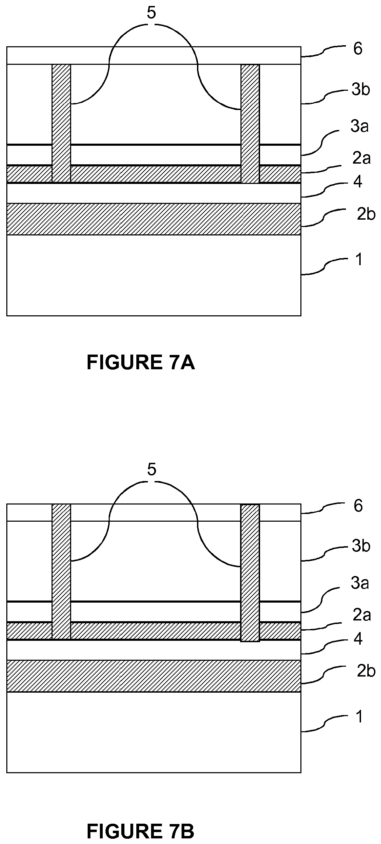

Selon un mode de réalisation optionnel mais avantageux, en référence à la figure 7A, on recouvre la couche active 3 dans laquelle ont été formées les tranchées d'isolation 5 d'une couche de confinement optique 6 présentant un coefficient de réflexion optique de la face avant vers la couche active supérieur au coefficient de réflexion de la couche active vers la face avant. Ladite couche de confinement optique 6 est constituée d'un empilement de couches qui assurent une telle sélectivité de la réflectivité en fonction du sens du photon incident. Selon un mode de réalisation préféré, ladite couche de confinement optique 6 comprend une couche de nitrure de titane entre deux couches d'oxyde de silicium présentant des épaisseurs différentes. Un avantage d'un tel empilement est qu'il est compatible avec les procédés utilisés en micro-électronique ; la formation de la couche de confinement optique peut donc être aisément intégrée dans le procédé de fabrication du capteur d'image. Par exemple, la couche de confinement optique 6 comprend, de la face avant vers la face arrière, une couche de SiO₂ de 100 nm d'épaisseur, une couche de TiN de 10 nm d'épaisseur et une couche de SiO₂ de 200 nm d'épaisseur. La réflectivité d'un tel empilement de la face avant du capteur vers la couche active est de 0,5%, tandis que sa réflectivité de la couche active vers la face avant est de 37%.

Ladite couche de confinement optique 6 laisse passer le rayonnement incident sur la surface du capteur d'image sensiblement sans le réfléchir, mais réfléchit en revanche les photons présents dans la couche active et réfléchit par la structure double BOX, ce qui a pour effet de les emprisonner dans la couche active et d'augmenter la longueur de leur parcours dans la couche active. Ladite couche de confinement optique permet ainsi d'augmenter l'absorption optique de la couche active.

Selon un mode de réalisation illustré à la figure 7B, les tranchées 5 électriquement isolantes s'étendent également dans la couche de confinement optique 6. Cette configuration permet avantageusement d'isoler électriquement, l'un par rapport à l'autre, deux pixels (ou deux capteurs d'image) adjacents même au niveau de la couche de confinement, notamment pour éviter des effets parasites ou d'ombrage.

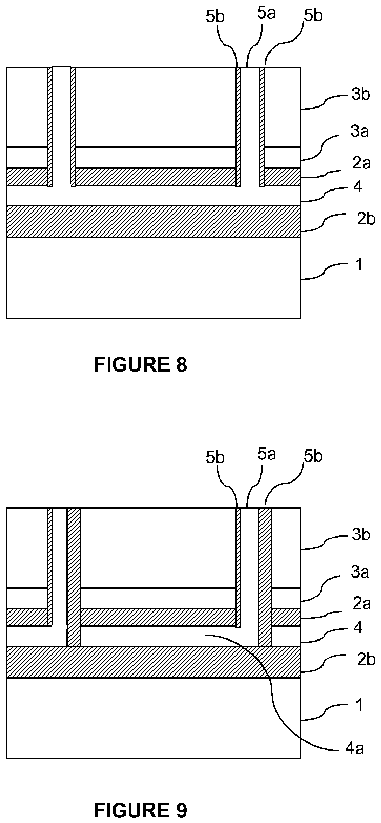

Selon un mode de réalisation illustré sur la figure 8, il est possible de polariser entièrement (c'est-à-dire sur toute son épaisseur) chaque pixel. A cet effet, chaque tranchée 5 est formée d'un via semi-conducteur 5a, par exemple en silicium, ou électriquement conducteur, s'étendant jusqu'à la couche intermédiaire 4 entre des parois 5b en un matériau électriquement isolant. Cette disposition est particulièrement avantageuse en ce qu'elle permet, avec une prise de contact unique, de polariser l'ensemble du pixel puisque les couches semi-conductrices 5a et 4 sont électriquement connectées.

Enfin, selon un mode de réalisation illustré sur la figure 9, il est possible de polariser entièrement et de manière indépendante chaque pixel. En effet, en ajustant la profondeur et les épaisseurs des parois intérieures et extérieures 5b de chaque tranchée, chaque pixel peut être polarisé indépendamment du pixel adjacent. Par exemple, chaque pixel peut être délimité d'un côté (côté droit pour le pixel central de la figure 9) par une paroi 5b en un matériau électriquement isolant relativement mince qui s'étend jusqu'à la couche intermédiaire 4, et d'un autre côté (côté gauche pour le pixel central de la figure 9) par une paroi 5b en un matériau électriquement isolant relativement épais qui s'étend au moins en partie dans la seconde couche de séparation 2b. La portion 4a de la couche intermédiaire 4 située sous le pixel est connectée électriquement à la couche semi-conductrice 5a située uniquement d'un côté du pixel (côté droit pour le pixel central de la figure 9) et est isolée électriquement du reste de la couche intermédiaire 4. Ainsi, chaque pixel peut être avantageusement adressé de manière indépendante.

Bien que non représentée sur les figures 8 et 9, la couche de confinement optique pourrait être présente sur la couche active et être traversée ou non par les tranchées 5 comme représenté sur les figures 7B et 7A.

### Exemples

Des simulations numériques d'absorption optique ont été effectuées pour différents substrats, selon l'état de la technique (avec une seule couche d'oxyde de silicium entre le substrat support et la couche active, comme illustré sur la figure 1) et selon l'invention (avec une structure double BOX à entre le substrat support et la couche active, comme illustré sur la figure 5). Ladite structure double BOX est constituée de l'empilement suivant, de la face avant vers la face arrière du substrat :
- première couche de séparation 2a : SiO₂, 40 nm
- couche semi-conductrice intermédiaire 4 : silicium polycristallin, 100 nm
- seconde couche de séparation 2b : SiO₂, 150 nm.

La réflectivité d'un tel empilement est de l'ordre de 72% pour une longueur d'onde incidente de 940 nm.

Dans ces simulations, certains substrats sont recouverts d'une couche de confinement optique présentant une réflectivité de la face avant vers la couche active supérieure à la réflectivité de la couche active vers la face avant. Ladite couche de confinement optique est constituée de l'empilement suivant, de la face avant vers la face arrière du substrat : SiO₂, 100 nm / TiN, 10 nm / SiO₂, 200 nm.

La couche active est constituée soit d'une couche de silicium de 6 µm d'épaisseur, soit d'une couche de SiGe de 2 µm d'épaisseur présentant une concentration en germanium égale à 10%.

Le tableau ci-dessous indique le coefficient d'absorption optique dans la couche active, pour un rayonnement incident normal (perpendiculaire à la face avant du substrat) et présentant une longueur d'onde de 940 nm. La simulation ne prend pas en compte l'influence de la diffraction ni de la réfraction sur les tranchées séparant les différents pixels.

| | | | | | | |
|---|---|---|---|---|---|---|
| **Couche de confinement optique** | Non | Non | Non | Oui | Oui | Oui |
| **Interface substrat support-couche active** | SiO₂ 30 nm | Double BOX | Double BOX | SiO₂ 30 nm | Double BOX | Double BOX |
| **Couche active** | Si 6 µm | Si 6 µm | Si_{0,9}Ge_{0,1} 2 µm | Si 6 µm | Si 6 µm | Si_{0,9}Ge_{0,1} 2 µm |
| **Coefficient d'absorption optique** | 33% | 47% | 49% | 47% | 68% | 87% |

On constate un gain significatif en absorption dès lors que l'on utilise une structure double BOX au lieu d'une unique couche de SiO₂. L'absorption optique est encore améliorée avec la réalisation de la couche active en SiGe au lieu du silicium, et/ou avec l'ajout de la couche de confinement optique qui confine les photons dans la couche active.

## Revendications

1. Capteur d'image de type face avant, comprenant successivement :
- un substrat support (1) semi-conducteur,
- une première couche de séparation électriquement isolante (2a), et
- une couche (3) semi-conductrice, monocristalline, dite couche active, comprenant un réseau matriciel de photodiodes, agencée du côté de la face avant du capteur, ledit capteur d'image étant **caractérisé en ce qu'**il comprend en outre, entre le substrat support (1) et la première couche électriquement isolante (2a) :
- une seconde couche de séparation électriquement isolante (2b) et
- une seconde couche électriquement conductrice ou semi-conductrice (4), dite couche intermédiaire, agencée entre la seconde couche de séparation (2b) et la première couche de séparation (2a), la seconde couche de séparation (2b) étant plus épaisse que la première couche de séparation (2a).

2. Capteur d'image selon la revendication 1, dans lequel la première couche de séparation (2a) présente une épaisseur comprise entre 10 et 100 nm.

3. Capteur d'image selon l'une des revendications 1 ou 2, dans lequel la seconde couche de séparation (2b) présente une épaisseur comprise entre 100 et 300 nm.

4. Capteur d'image selon l'une des revendications 1 à 3, dans lequel la couche intermédiaire (4) est en un matériau choisi parmi : un matériau amorphe ou polycristallin dopé, du silicium dopé, ou un matériau métallique.

5. Capteur d'image selon l'une des revendications 1 à 4, dans lequel la couche intermédiaire (4) présente une épaisseur comprise entre 20 et 150 nm.

6. Capteur d'image selon l'une des revendications 1 à 5, dans lequel la couche active (3) comprend une couche germe (3a) de silicium.

7. Capteur d'image selon l'une des revendications 1 à 5, dans lequel la couche active (3) comprend une couche germe (3a) de silicium-germanium.

8. Capteur d'image selon l'une des revendications 6 ou 7, dans lequel la couche active (3) comprend en outre une couche (3b) monocristalline de silicium-germanium sur la couche germe (3a).

9. Capteur d'image selon la revendication 8, dans lequel la teneur en germanium de la couche (3b) de silicium-germanium est inférieure ou égale à 10%.

10. Capteur d'image selon l'une des revendications 8 ou 9, dans lequel l'épaisseur de la couche (3b) de silicium-germanium est inférieure à une épaisseur critique définie comme étant une épaisseur au-delà de laquelle une relaxation du silicium-germanium se produit.

11. Capteur d'image selon la revendication 6, dans lequel la couche active (3) comprend en outre une couche monocristalline de silicium sur la couche germe.

12. Capteur d'image selon l'une des revendications 1 à 11, comprenant en outre, sur la couche active (3), une couche (6) dite couche de confinement optique présentant un coefficient de réflexion optique de la face avant vers la couche active supérieur au coefficient de réflexion de la couche active vers la face avant, ladite couche de confinement optique (6) comprenant une couche de nitrure de titane entre deux couches d'oxyde de silicium.

13. Capteur d'image selon l'une des revendications 1 à 12, dans lequel chaque photodiode est séparée d'une photodiode adjacente par au moins une tranchée (5) électriquement isolante s'étendant jusqu'à la première couche (2a) électriquement isolante.

14. Capteur d'image selon la revendication 13, dans lequel ladite tranchée comprend un via semi-conducteur ou électriquement conducteur (5a) s'étendant jusqu'à la couche intermédiaire (4) entre des parois (5b) en un matériau électriquement isolant.

15. Capteur d'image selon l'une des revendications 13 ou 14 dans sa relation de dépendance vis-à-vis de la revendication 12, dans lequel ladite au moins une tranchée (5) s'étend au travers de la couche (6) de confinement optique.

16. Capteur d'image selon la revendication 14, dans lequel chaque tranchée (5) comprend une première paroi (5b) s'étendant jusqu'à la couche intermédiaire (4) et une seconde paroi (5b) s'étendant au moins en partie dans la seconde couche de séparation (2b) de sorte à isoler électriquement une portion de la couche intermédiaire (4), le via semi-conducteur ou électriquement conducteur (5a) étant connecté électriquement à ladite portion de la couche intermédiaire (4).

17. Procédé de fabrication d'un capteur d'image de type face avant, comprenant les étapes suivantes :
- fourniture d'un premier substrat donneur (40),
- formation d'une zone de fragilisation (41) dans ledit premier substrat donneur, de sorte à délimiter une première couche (4) semi-conductrice,
- transfert de ladite première couche (4) sur un substrat support (1) semi-conducteur, une couche (2b) électriquement isolante, dite seconde couche de séparation, étant à l'interface entre le substrat donneur (40) et le substrat support (1) de sorte à former une structure comprenant le substrat support (1), la couche (2b) électriquement isolante, et la couche (4) transférée,
- fourniture d'un second substrat donneur (30),
- formation d'une zone de fragilisation (31) dans ledit second substrat donneur, de sorte à délimiter une couche semi-conductrice monocristalline (3a),
- transfert de ladite couche semi-conductrice monocristalline (3a) sur la structure, une couche (2a) électriquement isolante, dite première couche de séparation, étant à l'interface entre le second substrat donneur (30) et la structure, de sorte à former un ensemble comprenant successivement le substrat support (1), la seconde couche de séparation (2b), la première couche (4) semi-conductrice, la première couche de séparation (2a) et la couche semi-conductrice monocristalline (3a) transférée, la seconde couche de séparation (2b) étant plus épaisse que la première couche de séparation (2a),
- croissance épitaxiale d'une couche semi-conductrice monocristalline (3b) sur la couche semi-conductrice monocristalline (3a) transférée, ladite couche épitaxiale semi-conductrice monocristalline (3b) formant, avec la couche semi-conductrice monocristalline (3a) transférée, une couche active (3) du capteur d'image agencée du côté de la face avant du capteur, adaptée pour former un réseau matriciel de photodiodes.

18. Procédé de fabrication d'un capteur d'image de type face avant, comprenant les étapes suivantes :
- formation d'une structure par dépôt d'une couche (4) semi-conductrice ou électriquement conductrice sur un substrat support (1) recouvert d'une couche électriquement isolante (2b), dite seconde couche de séparation,
- fourniture d'un substrat donneur (30),
- formation d'une zone de fragilisation (31) dans ledit substrat donneur (30), de sorte à délimiter une couche semi-conductrice monocristalline (3a),
- transfert de ladite couche semi-conductrice monocristalline (3a) sur la structure, une couche (2a) électriquement isolante, dite première couche de séparation, étant à l'interface entre le substrat donneur (30) et la structure, de sorte à former un ensemble comprenant successivement le substrat support (1), la seconde couche de séparation (2b), la couche (4) semi-conductrice ou électriquement conductrice, la première couche de séparation (2a) et la couche semi-conductrice monocristalline (3a) transférée, la seconde couche de séparation (2b) étant plus épaisse que la première couche de séparation (2a),
- croissance épitaxiale d'une couche semi-conductrice monocristalline (3b) sur la couche semi-conductrice monocristalline (3a) transférée, ladite couche épitaxiale semi-conductrice monocristalline (3b) formant, avec la couche semi-conductrice monocristalline (3a) transférée, une couche active (3) du capteur d'image agencée du côté de la face avant du capteur, adaptée pour former un réseau matriciel de photodiodes.

19. Procédé selon l'une des revendications 17 ou 18, comprenant en outre la formation d'une couche (6) dite de confinement optique sur la couche active (3), ladite couche (6) de confinement optique présentant un coefficient de réflexion optique de la face avant vers la couche active supérieur au coefficient de réflexion de la couche active vers la face avant, ladite couche de confinement optique (6) comprenant une couche de nitrure de titane entre deux couches d'oxyde de silicium.

20. Procédé selon l'une des revendications 17 à 19, comprenant en outre la formation d'un réseau matriciel de photodiodes dans la couche active (3).

## Patentansprüche

1. Frontseitiger Bildsensor, der nacheinander umfasst:
- ein halbleitendes Trägersubstrat (1),
- eine erste elektrisch isolierende Trennschicht (2a), und
- eine einkristalline halbleitende Schicht (3), bezeichnet als aktive Schicht, die ein Photodioden-Matrixnetzwerk umfasst, die auf der Frontseite des Sensors eingerichtet ist,
wobei der Bildsensor **dadurch gekennzeichnet ist, dass** er ferner zwischen dem Trägersubstrat (1) und der ersten elektrisch isolierenden Schicht (2a) umfasst:
- eine zweite elektrisch isolierende Trennschicht (2b) und
- eine zweite elektrisch leitende oder halbleitende Schicht (4), bezeichnet als Zwischenschicht, die zwischen der zweiten Trennschicht (2b) und der ersten Trennschicht (2a) eingerichtet ist, wobei die zweite Trennschicht (2b) dicker als die erste Trennschicht (2a) ist.

2. Bildsensor nach Anspruch 1, wobei die erste Trennschicht (2a) eine Dicke zwischen 10 und 100 nm aufweist.

3. Bildsensor nach einem der Ansprüche 1 oder 2, wobei die zweite Trennschicht (2b) eine Dicke zwischen 100 und 300 nm aufweist.

4. Bildsensor nach einem der Ansprüche 1 bis 3, wobei die Zwischenschicht (4) aus Material ist, das ausgewählt ist aus: einem dotierten amorphen oder polykristallinen Material, dotiertem Silicium oder einem metallischen Material.

5. Bildsensor nach einem der Ansprüche 1 bis 4, wobei die Zwischenschicht (4) eine Dicke zwischen 20 und 150 nm aufweist.

6. Bildsensor nach einem der Ansprüche 1 bis 5, wobei die aktive Schicht (3) eine Silizium-Keimschicht (3a) umfasst.

7. Bildsensor nach einem der Ansprüche 1 bis 5, wobei die aktive Schicht (3) eine Silizium-Germanium-Keimschicht (3a) umfasst.

8. Bildsensor nach einem der Ansprüche 6 oder 7, wobei die aktive Schicht (3) ferner eine einkristalline Silizium-Germanium-Schicht (3b) auf der Keimschicht (3a) umfasst.

9. Bildsensor nach Anspruch 8, wobei der Germaniumgehalt der Silizium-Germanium-Schicht (3b) kleiner oder gleich 10 % ist.

10. Bildsensor nach einem der Ansprüche 8 oder 9, wobei die Dicke der Silizium-Germanium-Schicht (3b) kleiner als eine kritische Dicke ist, die als eine Dicke definiert ist, jenseits der eine Relaxation des Silizium-Germaniums auftritt.

11. Bildsensor nach Anspruch 6, wobei die aktive Schicht (3) ferner eine einkristalline Siliziumschicht auf der Keimschicht umfasst.

12. Bildsensor nach einem der Ansprüche 1 bis 11, umfassend ferner auf der aktiven Schicht (3) eine Schicht (6), bezeichnet als optische Confinement-Schicht, die einen optischen Reflexionskoeffizienten von der Frontseite zu der aktiven Schicht aufweist, der größer als der Reflexionskoeffizient von der aktiven Schicht zu der Frontseite ist, wobei die optische Confinement-Schicht (6) eine Titannitridschicht zwischen zwei Siliziumoxidschichten umfasst.

13. Bildsensor nach einem der Ansprüche 1 bis 12, wobei jede Photodiode von einer benachbarten Photodiode durch mindestens einen elektrisch isolierenden Graben (5) getrennt ist, der sich bis zu der ersten elektrisch isolierenden Schicht (2a) erstreckt.

14. Bildsensor nach Anspruch 13, wobei der Graben einen halbleitenden oder elektrisch leitenden Durchgangskontakt (5a) umfasst, der sich zwischen Wänden (5b) aus einem elektrisch isolierenden Material bis zu der Zwischenschicht (4) erstreckt.

15. Bildsensor nach einem der Ansprüche 13 oder 14 in dessen Abhängigkeit von Anspruch 12, wobei sich der mindestens eine Graben (5) durch die optische Confinement-Schicht (6) hindurch erstreckt.

16. Bildsensor nach Anspruch 14, wobei jeder Graben (5) eine erste Wand (5b), die sich bis zu der Zwischenschicht (4) erstreckt, und eine zweite Wand (5b) umfasst, die sich zumindest teilweise in die zweite Trennschicht (2b) erstreckt, so dass ein Abschnitt der Zwischenschicht (4) elektrisch isoliert wird, wobei der halbleitende oder elektrisch leitende Durchgangskontakt (5a) mit dem Abschnitt der Zwischenschicht (4) elektrisch verbunden ist.

17. Verfahren zur Herstellung eines frontseitigen Bildsensors, umfassend die folgenden Schritte:
- Bereitstellen eines ersten Donorsubstrats (40),
- Ausbilden einer Schwächungszone (41) in dem ersten Donorsubstrat, so dass eine erste halbleitende Schicht (4) abgegrenzt wird,
- Übertragen der ersten Schicht (4) auf ein halbleitendes Trägersubstrat (1), wobei sich eine elektrisch isolierende Schicht (2b), bezeichnet als zweite Trennschicht, an der Grenzfläche zwischen dem Donorsubstrat (40) und dem Trägersubstrat (1) befindet, so dass eine Struktur ausgebildet wird, die das Trägersubstrat (1), die elektrisch isolierende Schicht (2b) und die übertragene Schicht (4) umfasst,
- Bereitstellen eines zweiten Donorsubstrats (30),
- Ausbilden einer Schwächungszone (31) in dem zweiten Donorsubstrat, so dass eine einkristalline halbleitende Schicht (3a) abgegrenzt wird,
- Übertragen der einkristallinen halbleitenden Schicht (3a) auf die Struktur, wobei sich eine elektrisch isolierende Schicht (2a), bezeichnet als erste Trennschicht, an der Grenzfläche zwischen dem zweiten Donorsubstrat (30) und der Struktur befindet, so dass eine Anordnung ausgebildet wird, die nacheinander das Trägersubstrat (1), die zweite Trennschicht (2b), die erste halbleitende Schicht (4), die erste Trennschicht (2a) und die übertragene einkristalline halbleitende Schicht (3a) umfasst, wobei die zweite Trennschicht (2b) dicker als die erste Trennschicht (2a) ist,
- epitaktisches Aufwachsen einer einkristallinen halbleitenden Schicht (3b) auf der übertragenen einkristallinen halbleitenden Schicht (3a), wobei die epitaktische einkristalline halbleitende Schicht (3b) mit der übertragenen einkristallinen halbleitenden Schicht (3a) eine aktive Schicht (3) des Bildsensors bildet, die auf der Frontseite des Sensors eingerichtet ist, die zur Ausbildung eines Photodioden-Matrixnetzwerks geeignet ist.

18. Verfahren zur Herstellung eines frontseitigen Bildsensors, umfassend die folgenden Schritte:
- Ausbilden einer Struktur durch Abscheiden einer halbleitenden oder elektrisch leitenden Schicht (4) auf einem Trägersubstrat (1), das mit einer elektrisch isolierenden Schicht (2b), bezeichnet als Trennschicht, bedeckt ist,
- Bereitstellen eines Donorsubstrats (30),
- Ausbilden einer Schwächungszone (31) in dem Donorsubstrat (30), so dass eine einkristalline halbleitende Schicht (3a) abgegrenzt wird,
- Übertragen der einkristallinen halbleitenden Schicht (3a) auf die Struktur, wobei sich eine elektrisch isolierende Schicht (2a), bezeichnet als erste Trennschicht, an der Grenzfläche zwischen dem Donorsubstrat (30) und der Struktur befindet, so dass eine Anordnung ausgebildet wird, die nacheinander das Trägersubstrat (1), die zweite Trennschicht (2b), die halbleitende oder elektrisch leitende Schicht (4), die erste Trennschicht (2a) und die übertragene einkristalline halbleitende Schicht (3a) umfasst, wobei die zweite Trennschicht (2b) dicker als die erste Trennschicht (2a) ist,
- epitaktisches Aufwachsen einer einkristallinen halbleitenden Schicht (3b) auf der übertragenen einkristallinen halbleitenden Schicht (3a), wobei die epitaktische einkristalline halbleitende Schicht (3b) mit der übertragenen einkristallinen halbleitenden Schicht (3a) eine aktive Schicht (3) des Bildsensors bildet, die auf der Frontseite des Sensors eingerichtet ist, die zur Ausbildung eines Photodioden-Matrixnetzwerks geeignet ist.

19. Verfahren nach einem der Ansprüche 17 oder 18, umfassend ferner die Ausbildung einer Schicht (6), bezeichnet als optische Confinement-Schicht, auf der aktiven Schicht (3), wobei die optische Confinement-Schicht (6) einen optischen Reflexionskoeffizienten von der Frontseite zu der aktiven Schicht aufweist, der größer als der Reflexionskoeffizient von der aktiven Schicht zu der Frontseite ist, wobei die optische Confinement-Schicht (6) eine Titannitridschicht zwischen zwei Siliziumoxidschichten umfasst.

20. Verfahren nach einem der Ansprüche 17 bis 19, umfassend ferner die Ausbildung eines Photodioden-Matrixnetzwerks in der aktiven Schicht (3).

## Claims

1. A front-side imager comprising in succession:
- a semiconductor carrier substrate (1),
- a first electrically insulating separating layer (2a), and
- a single-crystal semiconductor layer (3), called the active layer, comprising a matrix array of photodiodes, located on the front side of the sensor,
said imager being **characterized in that** it further comprises, between the carrier substrate (1) and the first electrically insulating layer (2a):
- a second electrically insulating separating layer (2b), and
- a second semiconductor or electrically conductive layer (4), called the intermediate layer, arranged between the second separating layer (2b) and the first separating layer (2a), the second separating layer (2b) being thicker than the first separating layer (2a).

2. The imager as claimed in claim 1, wherein the first separating layer (2a) has a thickness comprised between 10 and 100 nm.

3. The imager as claimed in either of claims 1 and 2, wherein the second separating layer (2b) has a thickness comprised between 100 and 300 nm.

4. The imager as claimed in one of claims 1 to 3, wherein the intermediate layer (4) is made of a material selected from: a doped polycrystalline or amorphous material, doped silicon, or a metal.

5. The imager as claimed in one of claims 1 to 4, wherein the intermediate layer (4) has a thickness comprised between 20 and 150 nm.

6. The imager as claimed in one of claims 1 to 5, wherein the active layer (3) comprises a silicon seed layer (3a).

7. The imager as claimed in one of claims 1 to 5, wherein the active layer (3) comprises a silicon-germanium seed layer (3a).

8. The imager as claimed in either of claims 6 and 7, wherein the active layer (3) further comprises a single-crystal layer (3b) of silicon-germanium on the seed layer (3a).

9. The imager as claimed in claim 8, wherein the germanium content in the silicon-germanium layer (3b) is lower than or equal to 10%.

10. The imager as claimed in either of claims 8 and 9, wherein the thickness of the silicon-germanium layer (3b) is smaller than a critical thickness defined as being a thickness beyond which the silicon-germanium relaxes.

11. The imager as claimed in claim 6, wherein the active layer (3) further comprises a single-crystal layer of silicon on the seed layer.

12. The imager as claimed in one of claims 1 to 11, further comprising, on the active layer (3), a layer (6) called the optical confinement layer having a coefficient of optical reflection from the front side toward the active layer higher than the coefficient of reflection from the active layer toward the front side, said optical confinement layer (6) comprising a layer of titanium nitride between two layers of silicon oxide.

13. The imager as claimed in one of claims 1 to 12, wherein each photodiode is separated from an adjacent photodiode by at least one electrically isolating trench (5) extending up to the first electrically insulating layer (2a).

14. The imager as claimed in claim 13, wherein said trench comprises an electrically conductive or semiconductor via (5a) extending up to the intermediate layer (4) between walls (5b) made of an electrically insulating material.

15. The imager as claimed in either of claims 13 and 14 when dependent on claim 12, wherein said at least one trench (5) extends through the optical confinement layer (6).

16. The imager as claimed in claim 14, wherein each trench (5) comprises a first wall (5b) extending up to the intermediate layer (4) and a second wall (5b) extending at least partially into the second separating layer (2b) so as to electrically isolate a segment of the intermediate layer (4), the electrically conductive or semiconductor via (5a) being electrically connected to said segment of the intermediate layer (4).

17. A process for manufacturing a front-side imager, comprising the following steps:
- providing a first donor substrate (40),
- forming a weakened zone (41) in said first donor substrate, so as to delineate a first semiconductor layer (4),
- transferring said first layer (4) to a semiconductor carrier substrate (1), an electrically insulating layer (2b), called second separating layer, being at the interface between the donor substrate (40) and the carrier substrate (1) so as to form a structure comprising the carrier substrate (1), the electrically insulating layer (2b), and the transferred layer (4),
- providing a second donor substrate (30),
- forming a weakened zone (31) in said second donor substrate, so as to delineate a single-crystal semiconductor layer (3a),
- transferring said single-crystal semiconductor layer (3a) to the structure, an electrically insulating layer (2a), called first separating layer, being at the interface between the second donor substrate (30) and the structure, so as to form an assembly comprising successively the carrier substrate (1), the second separating layer (2b), the first semiconductor layer (4), the first separating layer (2a) and the transferred single-crystal semiconductor layer (3a), the second separating layer (2b) being thicker than the first separating layer (2a),
- growing epitaxially a single-crystal semiconductor layer (3b) on the transferred single-crystal semiconductor layer (3a), said epitaxial single-crystal semiconductor layer (3b) forming, with the transferred single-crystal semiconductor layer (3a), an active layer (3) of the imager located on the front side of the imager, adapted to form matrix array of photodiodes.

18. A process for manufacturing a front-side imager, comprising the following steps:
- forming a structure by depositing an electrically conductive or semiconductor layer (4) on a carrier substrate (1) covered with an electrically insulating layer (2b), called second separating layer,
- providing a donor substrate (30),
- forming a weakened zone (31) in said donor substrate (30), so as to delineate a single-crystal semiconductor layer (3a),
- transferring said single-crystal semiconductor layer (3a) to the structure, an electrically insulating layer (2a), called first separating layer, being at the interface between the second donor substrate (30) and the structure, so as to form an assembly comprising successively the carrier substrate (1), the second separating layer (2b), the electrically conductive or semiconductor layer (4), the first separating layer (2a) and the transferred single-crystal semiconductor layer (3a), the second separating layer (2b) being thicker than the first separating layer (2a),
- growing epitaxially a single-crystal semiconductor layer (3b) on the transferred single-crystal semiconductor layer (3a), said epitaxial single-crystal semiconductor layer (3b) forming, with the transferred single-crystal semiconductor layer (3a), an active layer (3) of the imager located on the front side of the imager, adapted to form a matrix array of photodiodes.

19. The process as claimed in either of claims 17 and 18, further comprising forming a layer (6) called the optical confinement layer on the active layer (3), said optical confinement layer (6) having a coefficient of optical reflection from the front side toward the active layer higher than the coefficient of reflection from the active layer toward the front side, said optical confinement layer (6) comprising a layer of titanium nitride between two layers of silicon oxide.

20. The process as claimed in one of claims 17 to 19, further comprising forming a matrix array of photodiodes in the active layer (3).
